Europäisches Patentamt

European Patent Office   (11) Publication number: **0 208 934**

Office européen des brevets   **A1**

(12) **EUROPEAN PATENT APPLICATION**

(21) Application number: 86108256.8

(51) Int. Cl.⁴: **H 01 L 29/06**

(22) Date of filing: 18.06.86

(30) Priority: 19.06.85 JP 133852/85

(43) Date of publication of application: 21.01.87 Bulletin 87/4

(84) Designated Contracting States: DE FR GB

(71) Applicant: FUJITSU LIMITED, 1015, Kamikodanaka Nakahara-ku, Kawasaki-shi Kanagawa 211 (JP)

(72) Inventor: Shirato, Takehide Fujitsu Ltd Patent Dept., Kosugi Fujitsu Building 1812-10, Shimonumabe, Nakahara-ku Kawasaki-shi Kanagawa, 211 (JP) Inventor: Ema, Taiji Fujitsu Ltd Patent Dept., Kosugi Fujitsu Building 1812-10, Shimonumabe, Nakahara-ku Kawasaki-shi Kanagawa, 211 (JP)

(74) Representative: Sunderland, James Harry et al, HASELTINE LAKE & CO Hazlitt House 28 Southampton Buildings Chancery Lane, London WC2A 1AT (GB)

(54) Narrow channel width fet.

(57) An integrated semiconductor circuit (IC) device comprising a metal insulator semiconductor field effect transistor (MISFET) having a narrow channel width, a field area (5) for isolating a source region, a drain region (both source and drain regions are not in the plane of the figure and are therefor not depicted), and a channel region (301) of the MISFET from other electrical elements of the IC device, and a channel stopper region (4), formed in the field area, for avoiding flow of leakage current between the MISFET and other electrical elements of the IC device. The source and the drain regions are separately arranged with the channel region between them, and the channel stopper region has structure such that it directly touches the source and the drain regions but is spaced apart from the channel region (as indicated by reference numeral 9) so that impurities of the channel stopper region do not go into the channel region, so that threshold voltage of the MISFET is not increased even when its channel width is as little as 2 microns.

0208934

## NARROW CHANNEL WIDTH FET

The present invention relates to a narrow channel width FET.

The achievement of high packing density is an important factor for integrated semiconductor circuit (IC) devices such as large scale integration (LSI) circuit devices or very large scale integration (VLSI) circuit devices. For the realization of high packing density, provision of MISFET channel widths and channel lengths which are narrow and short respectively is desired. The provision of channel stopper regions also contributes to the realization of high packing density, because the use of channel stopper regions between a MISFET and other electrical elements of an IC device can permit the distances between MISFET and the other electrical elements to be reduced.

However, when channel width is small, a problem has been experienced in that the provision of a channel stopper region can cause an increase in MISFET threshold voltage.

Generally, a channel stopper region has a high concentration of impurities and there is a tendency for a proportion of the impurities to invade the channel region of a MISFET. When the width of the channel region is reduced to 2 microns or less, a proportion of the impurities of the channel stopper region diffuses into the whole of/a substantial part of the channel region, which causes an increase in the impurity concentration in (throughout or substantially throughout) the channel region. Generally, in a MISFET, threshold voltage $V_{th}$ and impurity concentration of a channel region have a relationship such that the threshold voltage $V_{th}$ is proportional to the square root of the impurity concentration. Accordingly, the threshold voltage $V_{th}$ is increased to a high level when channel width is small and a channel stopper region is provided. Therefore, there is a requirement for a MISFET structure such that the impurity concentration of the channel region does not increase even though a channel stopper region is provided in relation to the MISFET and channel width is narrow.

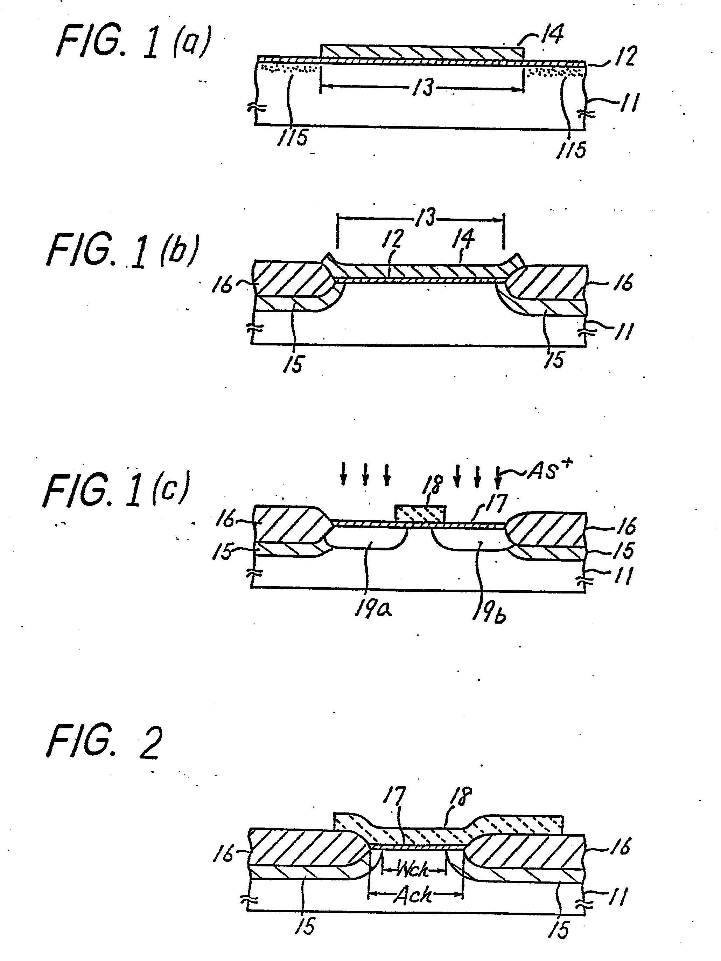

Figures 1(a), 1(b), and 1(c) are schematic cross sectional views illustrating the fabrication of a previously proposed MISFET.

Generally, MISFETs are divided into two types: an N channel type and a P channel type. Taking an N channel type as an example, a previously proposed MISFET can be fabricated as shown in Figures 1(a), 1(b) and 1(c).

The cross sections of Figures 1(a), 1(b) and 1(c) are taken in the channel length direction of the previously proposed MISFET.

In the previously proposed MISFET of Figures 1(a), 1(b) and 1(c), a transistor forming area (transistor area) 13 is fabricated in relation to a P type silicon substrate 11.

First, as shown in Figure 1(a), a thin silicon dioxide ($SiO_2$) layer 12 is formed on a surface of the silicon substrate 11 and an anti-oxidation layer pattern, such as a silicon nitride ($Si_3N_4$) layer pattern 14, is formed on the $SiO_2$ layer 12. The $Si_3N_4$ layer pattern 14 has a pattern suitable for forming transistor area 13.

Second, p type impurities such as boron ions ($B^+$) are injected with high concentration, so that a $B^+$ injection region 115 is formed in the silicon substrate 11 beneath the $SiO_2$ layer 12 as shown by dots in Figure 1(a). In this injection process the $Si_3N_4$ layer pattern 14 works as a mask so that there is no $B^+$ injection region 115 beneath the $Si_3N_4$ layer pattern 14.

Third, selective oxidation is effected using the $Si_3N_4$ layer pattern 14 as a mask, so that a field oxide layer 16 is formed at the surface of the Si substrate 11 except under the $Si_3N_4$ layer pattern 14. At the same time, a P type channel stopper region 15 is formed beneath the field oxide layer 16 by activating and re-distributing the $B^+$ injection region 115 as shown in Figure 1(b).

Fourth, a gate oxide layer 17 is formed on the transistor area 13 after chemical removal of the $Si_3N_4$ layer pattern 14 and the $SiO_2$ layer 12. A poly-crystalline silicon (poly-Si) gate electrode 18 is formed on the gate oxide layer 17 so as to be extended to a part of the field oxide layer 16.

Fifth, n type impurities (for example, arsenic ions ($A_s^+$) are injected into the transistor area 13 with high concentration using poly-Si gate electrode 18 as a mask.

Sixth, source and drain regions 19(a) and 19(b) are formed by activating and re-distributing the $A_s^+$ injection region when a re-flow treatment of an insulating layer (not shown in Figure 1(c)) existing between the layers is performed.

As mentioned above, in the fabrication of the previously proposed MISFET, the $B^+$ injection region 115 is formed by using the $Si_3N_4$ layer pattern 14 as a mask and thence the channel stopper region 15 is formed by activating and re-distributing the $B^+$ injection region 115 when field oxide layer 16 is formed using the $Si_3N_4$ layer pattern 14 as a mask. The channel stopper region 15 is laterally extended at right angles to the plane of the drawing of Figure 1(c). In other words, the channel stopper region 15 spreads in a channel width direction of the MISFET. Figure 2 is a cross section along a channel width direction of the MISFET, and illustrates the resulting problem. As shown in Figure 2, channel stopper regions 15, provided on opposite sides of the channel region and having high impurity concentration, invade the channel region of the MISFET, reducing a channel region width $A_{ch}$ to an effective channel width $W_{ch}$. The concentration of impurities in the channel region substantially increases, so that a threshold voltage $V_{th}$ of the MISFET increases.

The extent of the lateral diffusion at one side of the channel stopper region 15 (i.e. the extent of the invasion of the channel region by lateral diffusion of channel stopper impurities) is approximately equal to the depth of the channel stopper region 15. The depth of the channel stopper region 15 is usually 0.8 micron, so that the extent of the lateral diffusion is approximately 0.8 micron. Therefore, when the channel region width $A_{ch}$ is more than 10 microns, the extent of the lateral diffusion is relatively small compared with the effective channel width $W_{ch}$, so that increase of threshold voltage $V_{th}$ becomes negligible. However, when the channel region width $A_{ch}$ is as small as 2 microns (affording increased packing density and decreased power consumption for the MISFET) the effective channel width $W_{ch}$ becomes extremely small, for example 0.4 micron (2 microns - 0.8 micron x 2 = 0.4 micron). This leads to difficulties in controlling the driving capability of the MISFET and designing the IC device. In extreme cases, impurities for the channel stopper region diffuse laterally throughout the whole of the channel region. Accordingly, the threshold voltage $V_{th}$ of the MISFET becomes high. Thus, in the previous proposal there has been a problem in that there is a limit on the extent to which channel width $W_{ch}$ can be reduced, which causes problems in the design of IC devices.

According to the present invention there is provided an integrated semiconductor circuit device, formed on a semiconductor substrate of one conductivity type, having a field area for electrical isolation and a transistor area surrounded by said field area, the device comprising,

a metal insulator semiconductor field effect transistor, formed in said transistor area, having,

a source region, formed in said substrate and having a conductivity type opposite to said one conductivity type,

a drain region, formed in said substrate and having a conductivity type opposite to said one conductivity type,

a channel region, formed in said transistor area between said source region and drain region,

a gate insulating layer, formed on said channel region,

a gate electrode, formed on said gate insulator layer, and

a channel stopper region, formed in said field area, having said one conductivity type with a higher impurity concentration than said substrate, said channel stopper region being formed in contact with said source region and said drain region, but a part of said channel stopper region adjacent said channel region being spaced apart from said channel region.

According to the present invention there is provided an integrated semiconductor circuit device, formed on a well formed on a semiconductor substrate of one conductivity type, said well having a conductivity type opposite to said one conductivity type and having a field area for electrical isolation and a transistor area surrounded by said field area, the device comprising,

a metal insulator semiconductor field effect transistor formed in said transistor area, having,

a source region, formed in said well and having a conductivity type opposite to the conductivity type of said well, a drain region, formed in said well and having a conductivity type opposite to the conductivity type of said well,

a channel region, formed in said transistor area, between said source region and drain region,

a gate insulating layer, formed on said channel region, and

a gate electrode, formed on said gate insulator layer, and

a channel stopper region, formed in said field area and having the same conductivity type as the conductivity type of said well with higher impurity concentration than that of said well, said channel stopper region being formed in contact with said source region and said drain region, but a part of said channel stopper region adjacent to said channel region being spaced apart from said channel region.

An embodiment of the present invention can provide a MISFET which operates with a low threshold voltage even though the MISFET has a channel stopper region around it and has a narrow channel width.

An embodiment of the present invention can facilitate design of an IC device which includes a plurality of MISFETs having different channel widths, by making each MISFET operate with substantially the same low threshold voltage, even though channel width may be small for some MISFETs.

An embodiment of the present invention can offer an increased yield rate of a characteristic of each MISFET in an IC device which includes a plurality of MISFETs; the characteristic being such that the MISFET has a narrow channel width and operates under a low threshold voltage even though a channel stopper region is provided around the MISFET.

An embodiment of the present invention can provide an integrated semiconductor circuit device including a metal insulator semiconductor field effect transistor (MISFET) and a channel stopper region, in which , even when the MISFET has a channel region having narrow channel width ,the structure is such that effective extension of the channel stopper region into the channel region is avoided, for preventing the threshold voltage of the MISFET from increasing to a high level.

An embodiment of the present invention can provide a structure including a channel stopper region which is provided around a MISFET, for preventing leakage current from flowing between the MISFET and other electrical

0208934

elements of an IC device in which the MISFET is included, but which does not go into the channel region of the MISFET, so that the threshold voltage of the MISFET does not increase. The structure is provided by employing a mask in fabricating of the channel stopper region such that the channel stopper region does not invade the channel region even though channel width may be extremely narrow.

Reference is made, by way of example, to the accompanying drawings, in which:-

FIGURES 1(a), 1(b) and 1(c) are schematic cross-sectional views illustrating fabrication of a previously proposed MISFET:

FIGURE 2 is a cross-sectional view, taken in a channel width direction, of the previously proposed MISFET;

FIGURE 3(a) is a schematic plan view illustrating a MISFET in accordance with a first embodiment of the present invention;

FIGURE 3(b) is a schematic sectional view, taken along the line A-A' in Figure 3(a);

FIGURE 3(c) is a schematic sectional view taken along the line B-B' in Figure 3(a);

FIGURE 4(a) is a schematic plan view illustrating a CMOSFET structure according to a second embodiment of the present invention;

FIGURE 4(b) is a schematic cross-sectional view, taken along the line A-A' in Figure 4(a), and

FIGURES 5(a), 5(b), 5(c), 5(d), 5(e) and 5(f) are respective schematic cross-sectional views illustrating fabrication of the CMOSFET structure.

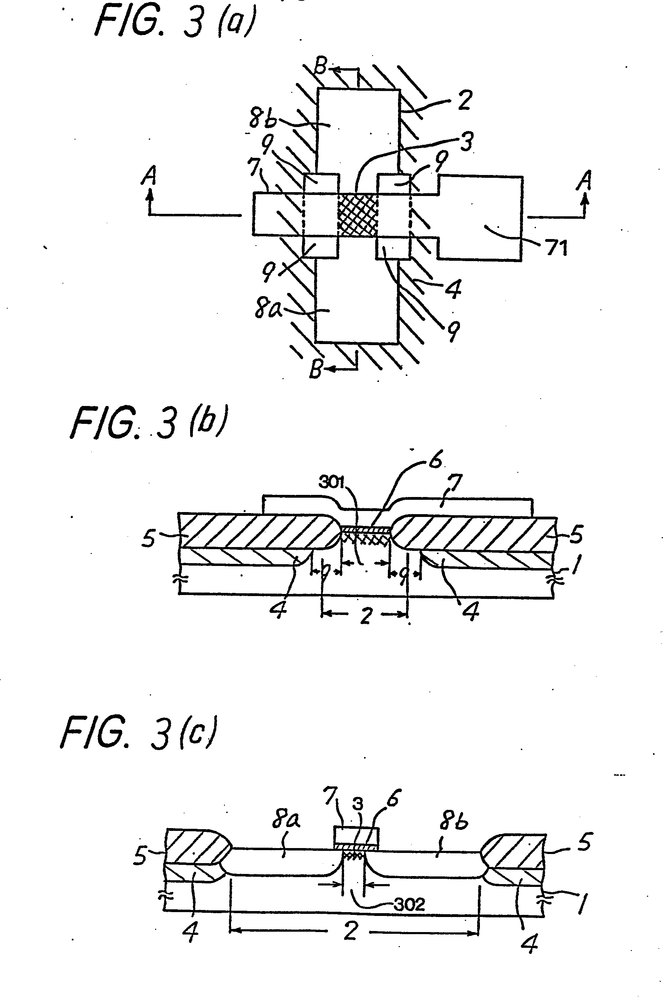

In Figures 3(a), 3(b) and 3(c), relating to a MISFET in accordance with a first embodiment of the present invention, similar reference signs designate similar elements or parts.

In Figure 3(a), oblique line hatching indicates a channel stopper region 4, which surrounds a transistor area 2, for avoiding leakage current flowing between transistor area 2 and neighboring electric elements of an IC device (not shown in Figures 3) in which the MISFET is formed.

A source region 8a and a drain region 8b are provided in the transistor area 2.

In Figures 3(a), 3(b) and 3(c), reference sign 7 indicates a gate electrode under which there is a channel region 3 which is indicated by cross-hatching.

Since the channel region 3 has a narrow channel width 301, as seen in Figure 3(b), and a short channel length 302, as seen in Figure 3(c), a gate terminal part 71 appears relatively large as compared with the channel region 3.

Since the channel stopper region 4 is adjacent to the transistor area 2 and since the channel region 3 has narrow channel width 301, if the MISFET were as previously proposed the threshold voltage of the MISFET would increase because the channel stopper region would effectively invade the channel region, as explained above.

However, in the first embodiment, a part, which is near the channel region 3, of the channel stopper region 4 is retreated by a channel-stopper retreat region 9 as shown in Figures 3(a) and 3(b). Accordingly, the channel width 301 can be kept narrow as desired; i.e. effective channel width 301 can be determined by a field insulating area (field area) 5 (to be called a field insulating layer or a field layer) provided for restricting the channel region 3 (without additional restriction of the channel region due to invasion by the channel stopper region). Therefore, increased MISFET threshold voltage can be avoided when the channel width 301 is extremely narrow. Thus, in accordance with an embodiment of the present invention a channel stopper retreat region 9 is afforded. Formation of such a channel stopper retreat region 9 will be discussed below.

0208934

In Figures 3(a) to 3(c), 1 is a semiconductor substrate, 6 is a gate insulator.

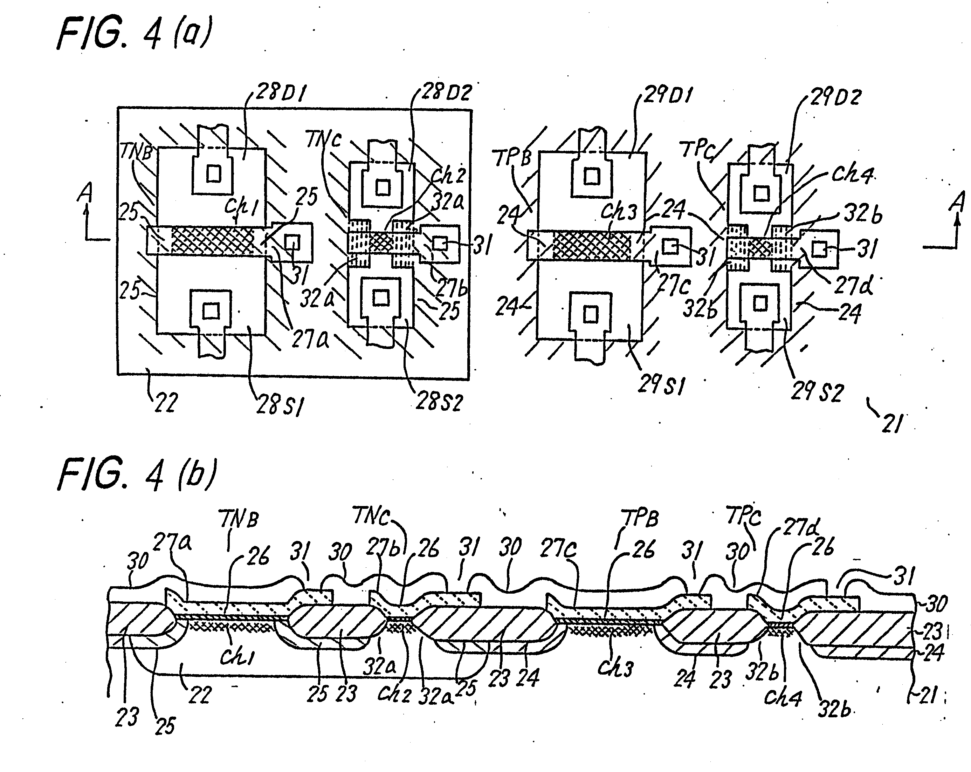

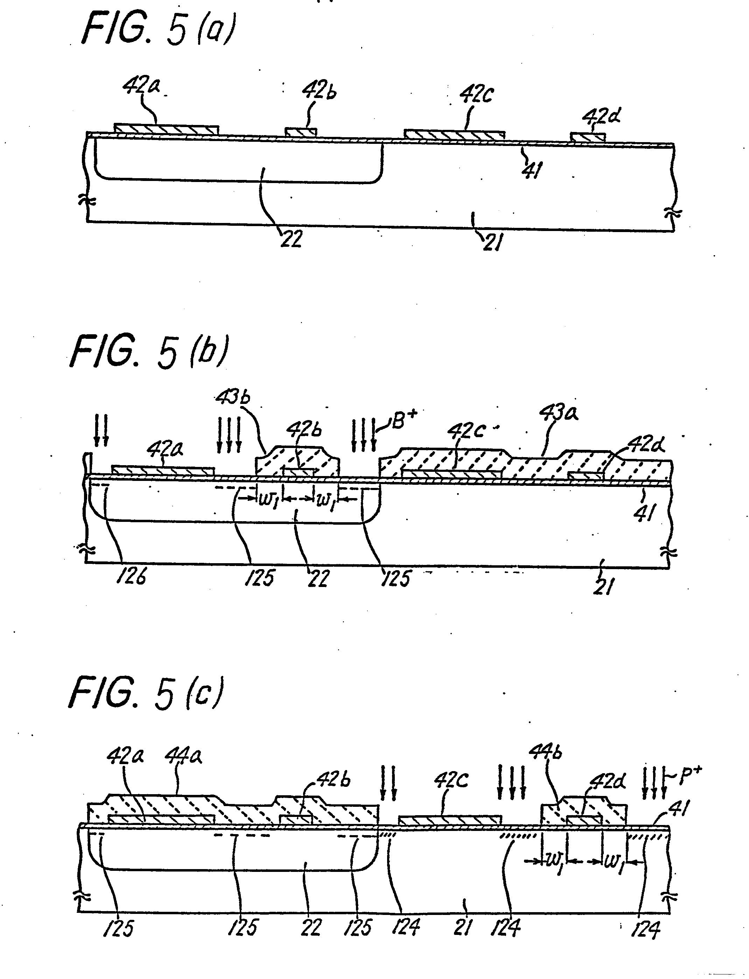

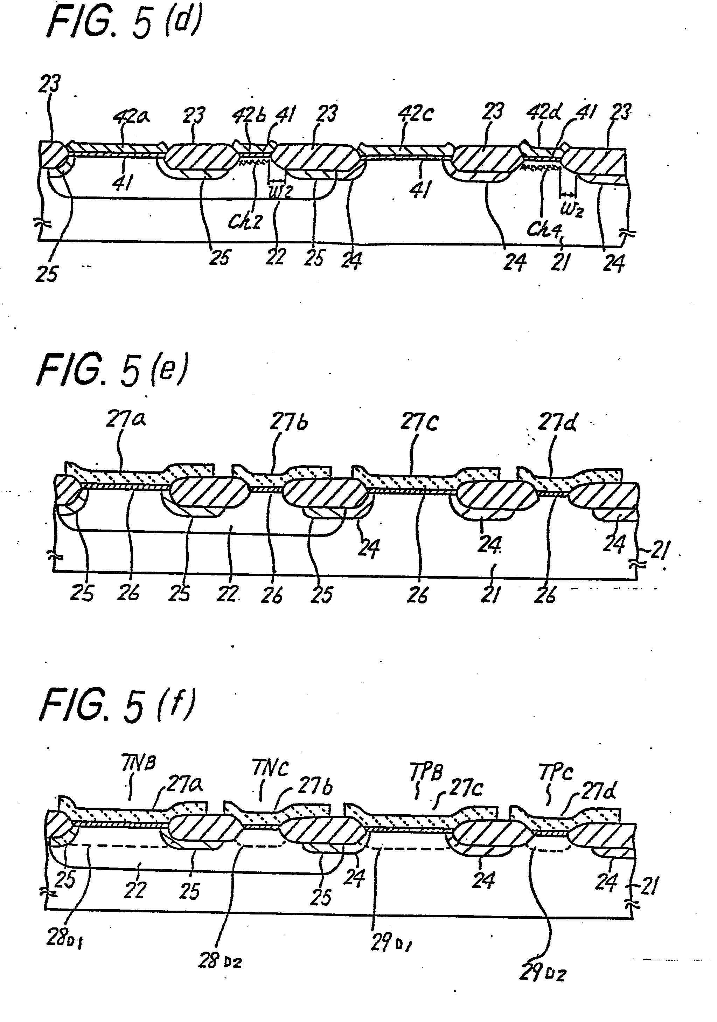

Figures 4(a) and 4(b) schematically illustrate a complementary metal oxide semiconductor FET (CMOSFET) structure in accordance with a second embodiment of the present invention; Figure 4(a) is a plan view of the CMOSFET structure and Figure 4(b) is a cross-sectional view taken along line A-A' in Figure 4(a). Figure 5(a) - 5(f) are cross-sectional views schematically illustrating fabrication of the CMOSFET structure shown in Figures 4. In Figures 4 and 5, similar reference signs designate similar elements or parts.

In Figures 4(a) and 4(b), $TN_B$ is an n type wide channel width MISFET, $TN_C$ is an n type narrow channel width MISFET, $TP_B$ is a p type wide channel width MISFET, and $TP_C$ is a p type narrow channel width MISFET.

Providing wide channel width and the narrow channel width MISFETs in a CMOSFET structure should be valuable because any combination of MISFETs, such as a combination of two wide channel width MISFETs, of two narrow channel width MISFETs, or of narrow and wide channel width MISFETs, can be selected in the design of the CMOSFET structure.

In Figures 4(a) and 4(b), p type wide channel width MISFET $TP_B$ and p type narrow channel width MISFET $TP_C$ are fabricated on an $n^-$ type silicon (Si) substrate 21, and n type wide channel width MISFET $TN_B$ and n type narrow channel width MISFET $TN_C$ are fabricated on a p type well 22 fabricated in the Si substrate 21.

The p type wide channel width MISFET $TP_B$ has a transistor area consisting of a drain region $29D_1$, a source region $29S_1$, and a channel region $ch_3$ having a wide channel width. A poly-Si gate electrode 27c has a contact window 31 (formed in insulator 30) and under the gate electrode 27c the wide width channel region $ch_3$ is located, between the regions $29D_1$ and $29S_1$, below the gate electrode 27c with an intervening gate insulating

SiO$_2$ layer 26. The transistor area is formed by a field SiO$_2$ layer 23 under which an n type channel stopper region 24 is formed. The n type channel stopper region 24, in the vicinity of the channel region ch$_3$, extends into the channel region, so that the effective width of the channel region ch$_3$ is reduced, as indicated by cross-hatching in Figures 4(a) and 4(b). However, the extent to which the channel region is invaded by the n type channel stopper region 24 is small ; each end of the length being invaded to the extent of approximately 0.8 micron as mentioned before. Compared with a (nominal or design) channel width which is generally more than 10 microns, the resultant reduction of the (effective) channel width of the MISFET TP$_B$ is negligible.

The p type narrow channel width MISFET TP$_C$ has a transistor area consisting of a drain region 29D$_2$, a source region 29S$_2$, and a channel region ch$_4$. A poly-Si gate electrode 27d has a contact window 31 and a narrow width channel region is located between regions 29D$_2$ and 29S$_2$ below gate electrode 27d with the intervention of a gate insulating SiO$_2$ layer 26. The transistor area is formed by a field SiO$_2$ layer under which a n type channel stopper region, 24 is formed. The above-mentioned structural features of MISFET TP$_C$ are similar to features of MISFET TP$_B$. However, in the case of TP$_C$, n type channel stopper region 24, near the channel region ch$_4$, cannot invade the channel region ch$_4$ because a channel-stopper retreat region 32b, shown by broken lines in Figure 4(a), is provided, so that effective channel width of the channel region ch$_4$ can be maintained to a designed value. Moreover, the threshold voltage of the MISFET TP$_C$ can be maintained substantially the same as that of the MISFET TP$_B$ even though the channel width is as little as 2 microns.

Wide channel width MISFET TN$_B$ and narrow channel width MISFET TN$_C$ have structures similar to those of TP$_B$ and TP$_C$ except that the former employ a p type channel stopper region 25.

In the MISFET $TN_B$, a transistor area consists of a drain region $28D_1$, a source region $28S_1$, and a gate electrode 27a having a contact window 31 and an effective channel region $ch_1$ having a wide channel width. In MISFET $TN_C$, a transistor area consists of a drain region $28D_2$, a source region $28S_2$, a gate electrode 27b having a contact window 31 and an effective channel region $ch_2$ having a narrow channel width, and a channel-stopper retreat region 32a indicated by broken lines in Figure 4(a). The function of the channel-stopper retreat region 32a is similar to that of the channel-stopper retreat region 32b of the MISFET $TP_C$.

The CMOSFET structure in Figures 4(a) and 4(b) can be fabricated easily, at low production cost, as illustrated in Figures 5(a), 5(b), 5(c), 5(d), 5(e) and 5(f), in order, which give cross-sectional views in channel width directions of channel regions of MISFETs as seen in Figures 4(a) and 4(b).

Figure 5(a) shows silicon nitride ($Si_3N_4$) layer patterns 42a to 42d and a first $SiO_2$ layer 41 formed on, and a p type well 22 formed in, a substrate 21 as follows:-

(1) providing $n^-$ type Si substrate 21 having a resistivity of approximately 1 ohm-cm;

(2) forming first $SiO_2$ layer 41, with a thickness of 500 to 600 angstroms, on the substrate 21;

(3) forming the $Si_3N_4$ layer patterns 42a, 42b, 42c and 42d on the first $SiO_2$ layer 41 using chemical vapor deposition (CVD) and photo-lithography so that the $Si_3N_4$ layer patterns selectively cover respective transistor forming areas; the $Si_3N_4$ layer patterns 42b and 42d covering transistor forming areas for transistors having a narrow channel width (such as 2 microns) and $Si_3N_4$ layer patterns 42a and 42c covering transistor forming areas for transistors having a wide channel width (such as 10 microns);

(4) selectively injecting boron ions ($B^+$) at a dose of approximately $1 \times 10^{13}$ ions $cm^{-2}$ into the $n^-$ type Si substrate 21 using a resist mask which is not shown in Figure 5(a), the $Si_3N_4$ layer patterns 42a and 42b, and the first $SiO_2$ layer 41, for forming the $p^-$ type well 22; and

(5) performing a designated annealing treatment in relation to the ion injected portion of substrate 21, so that the $p^-$ type well 22 is formed with approximately 5 microns thickness.

Figures 5(b) and 5(c) illustrate formation of a channel stopper retreat region as provided in this embodiment of the present invention.

As seen in Figure 5(b), a first resist layer pattern 43a is selectively formed so as to cover (over layer 41) the $n^-$ Si substrate 21 (outside the well 22), and a second resist layer pattern 43b is selectively formed so as to cover (over layer 41) a region of the $p^-$ type well 22 destined for the formation of a transistor having a narrow channel width. The second resist layer pattern 43b is selectively formed so as to cover (over layer 41) areas to both sides of the $Si_3N_4$ layer pattern 42b (as seen in Figure 5(b)); the coverage being such as to have an excess width $w_1$ (beyond each side of layer pattern 42b) of approximately 2.5 microns. The amount, 2.5 microns, of the excess width $w_1$ is determined taking into consideration channel stopper region depth and positioning margin for succeeding patterning processes.

Boron ions ($B^+$) are then selectively injected into the $p^-$ type well region 22 at a dosage of approximately $5 \times 10^{13}$ ions $cm^{-2}$, for forming a p type channel stopper region 125, which is shown in Figure 5(b), through the first $SiO_2$ layer 41, using the first resist layer pattern 43a, the second resist layer pattern 43b, and the $Si_3N_4$ layer pattern 42a as masking. Broken lines (125) in Figures 5(b) and 5(c) indicate the $B^+$ ion injection region.

After removing the first and the second resist layer patterns 43a and 43b, a third resist layer pattern 44a is formed (over layer 41), as seen in Figure 5(c), so as to selectively cover the $p^-$ type well 22. Also, a fourth resist layer pattern 44b is formed so as to selectively cover (over layer 41) the $Si_3N_4$ layer pattern 42d on the $n^-$ type Si substrate 21. The fourth resist layer pattern 44b is formed to selectively cover areas to both sides of the $Si_3N_4$ layer pattern 42d; the coverage being such as to have an excess width $w_1$ of approximately 2.5 microns (beyond each side of pattern 42d as seen in Figure 5(c). The amount, 2.5 microns, of excess width $w_1$ is determined in consideration of channel stopper region depth and positioning margin for succeeding patterning processes.

Phosphorus ions ($P^+$) are then injected into the $n^-$ type Si substrate 21 at a dosage of approximately $3 \times 10^{12}$ ions $cm^{-2}$, for forming a n type channel stopper region, through the first $SiO_2$ layer 41, using the third resist layer pattern 44a, the fourth resist layer pattern 44b, and the $Si_3N_4$ layer pattern 42c as masking. Dashes (124) in Figure 5(c) indicate the $P^+$ ion injection region.

After removing the third resist layer pattern 44a and the fourth resist layer pattern 44b, a field $SiO_2$ layer 23 (for separation of elements (MISFETs) of an (IC) is formed by selective oxidation using $Si_3N_4$ layer patterns 42a, 42b, 42c and 42d as masking. Then, the $B^+$ ion injection region 125 and the $P^+$ ion injection region 124 are activated and re-distributed, so that a p type channel stopper region 25 and an n type channel stopper region 24 are formed respectively to depths extending as much as 0.8 micron below the field $SiO_2$ layer 23.

As indicated with reference to Figures 5(b) and 5(c), when impurity ions such as the boron ions ($B^+$) or the phosphorus ions ($P^+$) are injected, the impurities are not injected into regions adjacent the (ultimate) channel regions of narrow channel width transistors ($TN_C$ and $TP_C$), because channel stopper regions 25 and 24 respectively relating to channel regions $ch_2$ and $ch_4$ are retreated (from those channel regions) to an extent $w_2$ of at least 0.8 micron as a result of the covering processes used in relation to the resist layer patterns 43b and 44b. $w_2$ is determined in consideration of the margin required in masking positioning and the lateral extension of the channel stopper region occurring in MISFET fabrication.

Further processes for fabricating the CMOSFET structure are performed as explained with reference to Figures 5(e) and 5(f).

As seen in Figure 5(e), after removing $Si_3N_4$ layer patterns 42a, 42b, 42c and 42d and first $SiO_2$ layer 41, a gate $SiO_2$ layer 26 is formed by thermal oxidation, and poly-Si gate electrodes 27a, 27b, 27c and 27d are formed using CVD and photo-lithography processes. In Figure 5(e), cross sections of the poly-Si gate electrodes in gate electrode width direction are seen.

As indicated in Figure 5(f), arsenic ions $(As^+)$ are selectively injected into the $p^-$ type well 22 using the gate electrodes 27a and 27b and a resist layer pattern, which is not shown in Figure 5(f), as masking, and boron ions $(B^+)$ are selectively injected into the $n^-$ type Si substrate 21 using gate electrodes 27c and 27d and a resist layer pattern, which is not shown in Figure 5(f), as masking.

Then, after a designated high temperature anneal treatment, $n^+$ type source regions and $n^+$ type drain regions, and $p^+$ type source regions and $p^+$ type drain regions are formed. The source and drain regions cannot properly be shown in Figure 5(f), because they are outside the plane of the cross-sectional view of Figure 5(f). Accordingly, $n^+$ type drain regions $28_{D1}$ and $28_{D2}$ and $p^+$ type drain regions $29_{D1}$ and $29_{D2}$ are indicated by broken lines. Then, the CMOSFET structure is completed by forming insulating layers and circuit wiring not shown in Figure 5(f).

As mentioned above, the n type wide channel width MISFET $TN_B$ and the n type narrow channel width MISFET $TN_C$ are formed on (in) a $p^-$ type well formed on (in) the semiconductor substrate and they constitute CMOSFETs with the p type wide channel width MISFET $TP_B$ or the p type narrow channel width MISFET $TP_C$ formed on the semiconductor substrate of the IC device. However, each of $TN_B$ and $TN_C$ can form a CMOSFET with only one of $TP_B$ and $TP_C$.

An integrated semiconductor circuit (IC) device comprising a metal insulator semiconductor field effect transistor (MISFET) having a narrow channel width, a field area for isolating a source region, a drain region, and a channel region of the MISFET from other electrical elements of the IC device, and a channel stopper region, formed in the field area, for avoiding flow of leakage current between the MISFET and other electrical elements of the IC device. The source and the drain regions are separately arranged with the channel region between them, and the channel stopper region has structure such that it directly touches the source and the drain regions but is spaced apart from the channel region so that impurities of the channel stopper region do not go into the channel region, so that threshold voltage of the MISFET is not increased even when its channel width is as little as 2 microns.

Claims:

1. An integrated semiconductor circuit device, formed on a semiconductor substrate of one conductivity type, having a field area for electrical isolation and a transistor area surrounded by said field area, the device comprising,

a metal insulator semiconductor field effect transistor, formed in said transistor area, having,

a source region, formed in said substrate and having a conductivity type opposite to said one conductivity type,

a drain region, formed in said substrate and having a conductivity type opposite to said one conductivity type,

a channel region, formed in said transistor area between said source region and drain region,

a gate insulating layer, formed on said channel region,

a gate electrode, formed on said gate insulator layer, and

a channel stopper region, formed in said field area, having said one conductivity type with a higher impurity concentration than said substrate, said channel stopper region being formed in contact with said source region and said drain region, but a part of said channel stopper region adjacent said channel region being spaced apart from said channel region.

2. A device as claimed in claim 1, wherein said channel width of said channel region is less than 2 microns.

3. An integrated semiconductor circuit device, formed on a well formed on a semiconductor substrate of one conductivity type, said well having a conductivity type opposite to said one conductivity type and having a field area for electrical isolation and a transistor area surrounded by said field area, the device comprising,

a metal insulator semiconductor field effect transistor formed in said transistor area, having,

a source region, formed in said well and having a conductivity type opposite to the conductivity type of said well, a drain region, formed in said well and having a conductivity type opposite to the conductivity type of said well,

a channel region, formed in said transistor area, between said source region and drain region,

a gate insulating layer, formed on said channel region, and

a gate electrode, formed on said gate insulator layer, and

a channel stopper region, formed in said field area and having the same conductivity type as the conductivity type of said well with higher impurity concentration than that of said well, said channel stopper region being formed in contact with said source region and said drain region, but a part of said channel stopper region adjacent to said channel region being spaced apart from said channel region.

4. A device as claimed in claim 3, wherein said channel width of said channel region is less than 2 microns.

FIG. 1 (a)

FIG. 1 (b)

FIG. 1 (c)

FIG. 2

FIG. 3 (a)

FIG. 3 (b)

FIG. 3 (c)

FIG. 4 (a)

FIG. 4 (b)

FIG. 5 (a)

FIG. 5 (b)

FIG. 5 (c)

415

0208934

## FIG. 5 (d)

## FIG. 5 (e)

## FIG. 5 (f)

0208934

**European Patent Office**

**EUROPEAN SEARCH REPORT**

Application number

EP 86 10 8256

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | GB-A-2 123 605 (STANDARD MICROSYSTEMS) * abstract; figures 2, 3; page 3, lines 11-108; claims 1-6 * | 1-4 | H 01 L 29/06 |
| A | US-A-4 404 579 (INC. MOTOROLA) * figures 6, 10; column 3, lines 12-54 * | 1 | |

|  |  | TECHNICAL FIELDS SEARCHED (Int. Cl.4) |
|---|---|---|
|  |  | H 01 L 29/06 |

The present search report has been drawn up for all claims

| Place of search | Date of completion of the search | Examiner |
|---|---|---|
| BERLIN | 27-08-1986 | PRETZEL B.C. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82